# EUROPEAN PATENT APPLICATION

(11) **EP 1 892 777 A2**
(43) Date of publication of application: **27.02.2008**
(21) Application number: 07113198.1
(22) Date of filing: 26.07.2007
(51) Int. Cl.: H01L 51/54

(54) **A light emitting device including anti-reflection layer(s)**

(30) Priority: 24.08.2006 US 509446
(71) Applicant: CORNING INC., Corning NY 14831 (US)
(72) Inventor: Boek, Heather Debra, Corning, NY 14830 (US); Langensiepen, Ralph A., Corning, NY 14830 (US); Maier, Robert LeRoy, Ontario, NY 14519 (US)
(74) Representative: Skuhra, Udo

(57) **Abstract**

A technique for reducing the appearance of Newton's Rings for a light emitting device is disclosed. The light emitting device comprises an anti-reflective coating on the inner surface of a cover substrate. A method of making a light emitting device is disclosed, together with a method for reducing the formation of Newton's Rings in a device.

## Description

### BACKGROUND OF THE INVENTION

### FIELD OF THE INVENTION

The present invention relates to light emitting devices and methods to reduce Newton's rings. More particularly, the present invention relates to light emitting devices having an anti-reflective (AR) coating to reduce the reflectance of emitted light and/or ambient light if a circular polarizer is not employed.

### TECHNICAL BACKGROUND

A newly developed type of flat panel display technology makes use of Organic Light Emitting Diode (OLED) and thin transparent electrode materials sandwiched between two thin glass panels. As the active light emitting materials are sensitive to damage by contaminants, including water and oxygen, the device perimeters are typically sealed to maintain a water and oxygen free environment. Commercially available sealant systems do not typically provide hermetic seals that survive over the lifetime of the display, and thus require a powerful desiccant be put inside the cell. The inclusion of a non-transparent desiccant requires that the light emitted from the OLED be directed through the matrix of electronic drivers and electrodes, i.e., "bottom emission," compromising the brightness of the display. A lasting hermetic seal allows the device to be "top emission," meaning that the emitted light is transmitted through a transparent cover substrate to preserve image brightness and clarity.

Ambient lighting can create visible interference fringes via constructive/destructive interference of the ambient light reflected from the inner surfaces of the OLED device. Light reflected at the interface of a low index of refraction medium and a high index of refraction medium, for example, air to an OLED, experiences a 180 degree phase reversal. Light reflected from the inside surface of the cover substrate combines with that reflected from the OLED surface, producing interference fringes at air-gap (path length) distances in multiples of λ/2.

Perfectly parallel plates with an air gap greater than λ/2 will create a uniform constructive interference color. Variations in the air gap thickness produce fringes in patterns analogous to contour lines, with line width and spacing inversely proportional to slope.

In order to make the devices as thin as possible, the gap between the glasses is targeted to be less than 100 microns, with recent targets less than 15 microns. In this gap range, interference fringes form and are visible under ambient lighting if the gap distance is not uniform. This interference pattern has been referred to as "Newton's Rings" or "NR"s.

Commercial pressures continuously require the production of thinner devices. As the thickness of the air gap decreases, it becomes more difficult to prevent Newton's Rings. Thus, it would be considered a significant advancement in the art to obtain a light emitting device that does not exhibit or substantially reduces the presence of Newton's Rings.

### SUMMARY OF THE INVENTION

The present invention relates to a light emitting display device that does not exhibit Newton's Rings, or minimizes the presence of Newton's Rings, and more particularly, to the use of an anti-reflective coating on the inner surface of a light emitting device cover substrate to reduce the internal reflection of ambient light and mitigate the formation of Newton's Rings.

In one aspect, the present invention provides a light emitting device comprising a cover substrate capable of transmitting light and having a first surface and a second surface oppositely disposed from the first surface, a support substrate, and a light emitting layer positioned between the cover substrate and the support substrate, wherein the light emitting layer emits light in the direction of the first surface of the cover substrate, and wherein the first surface of the cover substrate is coated with an anti-reflective material.

In another aspect, the present invention provides a method of making a light emitting device comprising: providing a cover substrate capable of transmitting light and having a first surface and a second surface oppositely disposed from the first surface wherein the first surface is coated with an anti-reflective material, a support substrate, and a light emitting layer; and positioning the light emitting layer between the cover substrate and the support substrate such that the light emitting layer emits light in the direction of the first surface of the cover substrate.

In another aspect, the present invention provides a method for reducing the formation of Newton's Rings in a device comprising: providing the device described above; and receiving ambient light onto the light emitting layer; thereby preventing at least a portion of the internally reflected ambient light from traversing the cover substrate.

Additional aspects of the invention will be set forth, in part, in the detailed description, figures and claims which follow, and in part will be derived from the detailed description, or can be learned by practice of the aspects invention described below. The advantages described below will be realized and attained by means of the elements and combinations particularly pointed out in the appended claims. It is to be understood that both the foregoing general description and the following detailed description are exemplary and explanatory only and are not restrictive of the invention as disclosed.

### BRIEF DESCRIPTION OF THE DRAWINGS

The accompanying drawings, which are incorporated in and constitute a part of this specification, illustrate certain aspects of the instant invention and together with the description, serve to explain, without limitation, the principles of the invention.

FIG. 1 is a schematic diagram illustrating a light emitting device with an anti-reflective coating, according to one aspect of the present invention.

FIG. 2 is a graph illustration of reflectance and wavelength for a single layer magnesium fluoride anti-reflective coating according to one aspect of the present invention.

FIG. 3 is a graph illustration of reflectance and wavelength for a 3 and a 12 layered anti-reflective coating for an angle of incidence of 0 degrees, according to one aspect of the present invention.

FIG. 4 is a graph illustration of reflectance and wavelength for a 3 and a 12 layered anti-reflective coating for an angle of incidence of 30 degrees, according to one aspect of the present invention.

FIG. 5 is a graph illustration of reflectance and wavelength for a 3 and a 12 layered anti-reflective coating for an angle of incidence of 45 degrees, according to one aspect of the present invention.

FIG. 6 is a graph illustration of reflectance and wavelength for a 3 and a 12 layered anti-reflective coating for an angle of incidence of 60 degrees, according to one aspect of the present invention.

FIG. 7 is a graph illustration of a multi-layer anti-reflective coating comprising niobium oxide and silica, according to one aspect of the present invention.

### DETAILED DESCRIPTION OF THE INVENTION

The present invention can be understood more readily by reference to the following detailed description, examples, and claims, and their previous and following description. However, before the present articles and/or methods are disclosed and described, it is to be understood that this invention is not limited to the specific articles and/or methods disclosed unless otherwise specified, as such can, of course, vary. It is also to be understood that the terminology used herein is for the purpose of describing particular aspects only and is not intended to be limiting.

The following description of the invention is provided as an enabling teaching of the invention in its currently known embodiment. To this end, those skilled in the relevant art will recognize and appreciate that many changes can be made to the various aspects of the invention described herein, while still obtaining the beneficial results of the present invention. It will also be apparent that some of the desired benefits of the present invention can be obtained by selecting some of the features of the present invention without utilizing other features. Accordingly, those who work in the art will recognize that many modifications and adaptations to the present invention are possible and can even be desirable in certain circumstances and are a part of the present invention. Thus, the following description is provided as illustrative of the principles of the present invention and not in limitation thereof.

In this specification and in the claims which follow, reference will be made to a number of terms which shall be defined to have the following meanings:

As used herein, the singular forms "a," "an" and "the" include plural referents unless the context clearly dictates otherwise. Thus, for example, reference to an "anti-reflective material" includes aspects having two or more such anti-reflective materials, unless the context clearly indicates otherwise.

Ranges can be expressed herein as from "about" one particular value, and/or to "about" another particular value. When such a range is expressed, another aspect includes from the one particular value and/or to the other particular value. Similarly, when values are expressed as approximations, by use of the antecedent "about," it will be understood that the particular value forms another aspect. It will be further understood that the endpoints of each of the ranges are significant both in relation to the other endpoint, and independently of the other endpoint.

As used herein, a "wt. %" or "weight percent" or "percent by weight" of a component, unless specifically stated to the contrary, refers to the ratio of the weight of the component to the total weight of the composition in which the component is included, expressed as a percentage.

"Optional" or "optionally" means that the subsequently described event or circumstance can or cannot occur, and that the description includes instances where the event or circumstance occurs and instances where it does not.

"Refraction" refers to the change in direction of a light ray passing from one medium to another of different density.

"Index of refraction" refers to the ratio of the velocity of light in a vacuum to its velocity in the substance or component described and can vary with the wavelength of the light.

"Angle of incidence" refers to the angle measured between the incident ray of light and the surface normal, and can include angles on both sides of normal.

"Surface normal" or "normal" means perpendicular to the plane of the substrate.

As used herein, "optical thickness" of a coating, unless specifically stated to the contrary, is the product of the physical thickness of the coating and the refractive index of the coating.

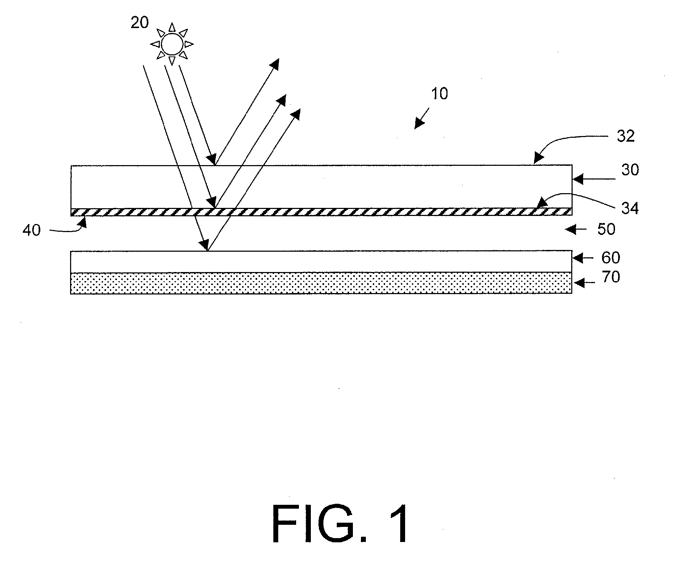

With reference now to the drawings, FIG. 1 is an illustrative schematic of a light emitting device 10 with an anti-reflective coating 40, according to one aspect of the present invention. It should be understood that this schematic is intended to illustrate one aspect of the present invention and is not intended to limit or preclude other aspects. It should also be noted that the schematic is not drawn to scale and that geometric variants may exist.

As briefly introduced above, the present invention provides a light emitting device 10 with an anti-reflective material 40 applied to the inner (first) surface 34 of a cover substrate 30, an air gap 50, a light emitting film 60, such as an OLED, and a support substrate 70. The anti-reflective material 40 of the present invention is intended to reduce the internal reflection of ambient light 20, and thus reduce the recombination of a phase changed reflection with light reflected from the surface of a light emitting film 60.

In one aspect, the intensity of top emitted light is preserved when using an anti-reflective coating. In another aspect, the clarity of an emitted image is preserved when using an anti-reflective coating.

In one aspect, the anti-reflective coating is compatible with a frit sealing process and the materials of composition for a light emitting device. In another aspect, the anti-reflective coating is compatible with a frit paste and the process of sintering and sealing a frit. In a further aspect, anti-reflective coatings are commercially available and can be manufactured and applied to cover substrate materials on a large scale in a cost efficient manner.

In another aspect, the anti-reflective coating is applied to both the outer (second) 32 and inner 34 surfaces of a cover substrate.

In another aspect, the present invention further provides a light emitting device comprising a multi-layer anti-reflective coating on the first surface of the cover substrate.

Accordingly, in one aspect, the anti-reflective coating of the present invention eliminates interference fringes that are visible to the viewer of a top emission light emitting display device. In another aspect, the anti-reflective coating of the present invention reduces the reflection of ambient light from the inner surface of a cover substrate, thus reducing the appearance or intensity of Newton's Rings visible to the viewer of a top emission light emitting device.

In one aspect, it is desirable that a device exhibit less than 1 percent reflectance of ambient light from the inner surface of the cover substrate. It is preferred that the device exhibit much less than 1 percent reflectance of ambient light from the inner surface of the cover substrate, for example, from 0 to about 0.2 % reflectance. In one aspect, the reflectivity of ambient light can be measured from 460 nm to 640 nm. In another aspect, the reflectivity of ambient light can be measured at 546 nanometers, a peak in the spectrum of fluorescent lighting and a common contributor to the appearance of Newton's Rings. In another aspect, the reflectivity of ambient light can be measured at 575 nanometers. In yet another aspect, the hermeticity and mechanical strength of a cover substrate seal are unaffected by the anti-reflective coating of the present invention.

In one aspect, it is desirable to eliminate or reduce the appearance of Newton's Rings at angles of incidence from 0 to about 30 degrees, preferably to about 45 degrees. Elimination of Newton's Rings at angles of incidence of 45 degrees will typically provide a usable viewing angle of 90 degrees for a given device, for example 45 degrees to each side of surface normal, and is acceptable for many products, for example, cellular telephones, digital cameras, handheld electronic and audio devices. In one aspect, the reflectance of ambient light in the range of 460 nanometers to 640 nanometers, from the inner surface of the cover substrate, is less than 1 percent when viewed from an angle of incidence of from 0 to about 30 degrees. In another aspect, the reflectance of ambient light at 546 nanometers and 575 nanometers, from the inner surface of the cover substrate, is less than 1 percent when viewed from an angle of incidence of from 0 to about 45 degrees.

The light emitting device of the present invention can be any device typically used as an electronic display, for example, an organic light emitting diode device. In one aspect, the light emitting device is a top emitting device, wherein emitted light is transmitted through a transparent cover substrate.

In a further aspect, the cover substrate of the light emitting device comprises a glass material. The glass material can be any glass that is suitable for use in a display device, for example, a silica, borosilicate, soda-lime, optical crown, spectacle crown, or a flint glass. In another aspect, the cover substrate is an Eagle ^{2000 ™} glass. In yet another aspect, the cover substrate comprises a plastic material.

**Anti-Reflective Materials**

Any anti-reflective coating can be used in the present invention, provided that the coating material is compatible with the materials of construction of the device. It is preferred that the anti-reflective coating material be inorganic, nonporous, and not retain water. As described above, moisture can be detrimental to some display technologies, for example, organic light emitting diodes, and organic or porous coating materials can compromise the hermetic seals of such devices.

In one aspect the anti-reflective coating can be a single layer of a low index of refraction material, such as, for example, magnesium fluoride, or a multilayered design of high index and low index materials such as, for example, niobium oxide, silica, or a mixture thereof. In another aspect, the anti-reflective coating can be a multilayered design. In a further aspect, such a multilayer design comprises, for example, at least one layer of magnesium fluoride and at least one layer of a metal oxide, that is transparent in the visible spectrum, for example, titania, tantala, alumina, cerium oxide, zirconia, hafnia, yttria, silicon monoxide, tin oxide, scandia, or other materials which exhibit appropriate index of refraction, transparency, and physical properties for anti-reflective coatings. Traditional anti-reflective coating materials are commercially available and one of skill in the art could readily select appropriate anti-reflective coating materials and designs for use in reducing the reflection of ambient light from the outer surface of a device. The present invention applies anti-reflective coating technology to the inner surface of a cover substrate to reduce internal reflections of ambient light and thus, reduce the appearance of Newton's Rings.

**Application of Anti-Reflective Coating**

Anti-reflective coatings are commonly vacuum deposited from physical vapor using an electron gun or resistance heating to melt the deposition materials. The depositing film can be bombarded during deposition with ions of argon and/or oxygen, or in a plasma environment, to produce a dense, stoichiometric film. Alternatively, a dense film can be sputtered in a vacuum environment. One such technique is DC sputtering, wherein target materials are bombarded by a DC plasma to dislodge atoms and molecules from the target and transported in line of sight fashion through a vacuum to the substrate to be coated. Multi-layer materials can be fabricated using continuous process equipment. Anti-reflective coatings and methods of deposition onto articles, such as lenses, are well known in the glass industry. As described above, the present invention applies an anti-reflective coating to the inner surface of the cover substrate of a light emitting device to reduce the appearance of Newton's Rings. One of skill in the art could readily select an appropriate material or mixture of materials, and deposit said material on a cover substrate for use in a light emitting device.

**Refractive Index and Thickness of Anti-Reflective Layers**

The performance of an anti-reflective coating, that is, the ability to reduce or eliminate reflections at a specific wavelength or range of wavelengths, is dependent upon both the thickness of the anti-reflective coating and the refractive index of the coating material. In one aspect, the thickness of the anti-reflective coating can range from greater than 0 to about 200 nanometers, for example, 1, 2, 10, 50, 100, 150, or 200 nanometers.

For a single layer anti-reflective coating, it is preferable that the optical thickness of the anti-reflective coating, defined as the physical thickness multiplied by the index of refraction, be approximately equal to one fourth of the wavelength of the light to which a reduced reflection is sought. Typically, the wavelength to which a reduced reflection is sought is a peak in the spectrum of ambient light incident on the device. It should be noted that it is not necessary that the thickness of the anti-reflective coating exactly match this value, but the performance of the anti-reflective coating will diminish as the thickness deviates from the desired value. It is also preferable that the target thickness be within 5 % of the nominal physical thickness. Variations within this range will have little effect on performance of the coating and are readily attainable in a manufacturing setting.

In one aspect, the anti-reflective coating reduces the reflectance of fluorescent light. On many display devices, reflections from fluorescent lighting can be more problematic than those from natural or incandescent lighting due to the fact that mercury emission peaks from common fluorescent ambient lighting, for example, 546 nanometers and 577/579 nanometers, coincide with peaks in the sensitivity of the human eye. Thus, for a target wavelength of about 560 nanometers, the preferable optical thickness of a single layer anti-reflective coating is about 140 nanometers (560 ÷ 4).

The refractive index of a single layer anti-reflective coating can also affect the coating's ability to reduce or eliminate the appearance of Newton's Rings. It is preferable that the anti-reflective coating have a refractive index approximately equal to the square root of the index of refraction of the cover substrate. If coating materials having the target refractive index are unavailable, other coating materials having a close or substantially similar refractive index can be substituted. Thus, for a borosilicate glass substrate with a refractive index of, for example, about 1.5, the target refractive index for a single layer coating material is about 1.23. A suitable material is, for example, magnesium fluoride, having a refractive index of about 1.38 at 560 nanometers. Thus, for a single layer coating having a preferable optical thickness of 140 nanometers and a refractive index of 1.38, the preferable physical thickness of a magnesium fluoride coating is about 101 nanometers (140 ÷ 1.38), with a tolerance of about ± 5 nanometers.

Due to variations in refractive index, specific materials of construction, for example, plastic, flint glass, or Eagle ^{2000 ™} glass, can require anti-reflective coatings of different refractive indices to sufficiently reduce the reflectivity of ambient light, and thus the appearance of Newton's Rings. As with the thickness of the anti-reflective coating, described above, it should be noted that it is not necessary that the anti-reflective coating material exhibit a refractive index exactly equal to the square root of the index of refraction of the cover substrate. Deviations from the preferred value can still result in a reduction or elimination of Newton's Rings, depending on the nature and composition of the cover substrate, along with the planarity of the light emitting material, the cover substrate, and the uniformity of the air gap between the cover substrate and the light emitting material. In one aspect, the refractive index of the anti-reflective coating is equal to the square root of the refractive index of the cover substrate. In another aspect, the refractive index of the anti-reflective coating is approximately equal to the square root of the refractive index of the cover substrate, such that reflection of ambient visible light is less than one percent.

As illustrated in the example below, a single layer anti-reflective coating can reduce the reflectivity of ambient light over a limited range of viewing angles of incidence, for example up to about 30 degrees. It is preferable to extend this viewing range to at least about 45 degrees by using greater than one layer of anti-reflective coating. In one aspect, the present invention comprises a device comprising an anti-reflective coating of at least 2 layers. In further aspects, the present invention comprises a device comprising an anti-reflective coating of at least 3 layers, at least 4 layers, at least 5 layers, or at least 10 layers. In further aspects, the present invention comprises a device comprising an anti-reflective coating of 2, 3, 4, 5, 10, or 12 layers.

A multilayer anti-reflective coating can have varying design thicknesses, dependent upon the actual design and refractive index of the specific coating materials available. Variations in layer thickness for multilayer coatings can also depend on the specific design, but are typically within the tolerances of modern manufacturing technologies.

For a two layer anti-reflective coating, it is preferable that the total optical film thickness is a half-wave, each layer being a quarter wave optical thickness. Reflectance, in such a coating system, can be reduced or eliminated when the refractive index of the layer closest to the substrate equals the product of the refractive index of the second layer and the square root of the refractive index of the substrate. For a two layer coating on a borosilicate substrate, for example, wherein the second layer (layer not closest to the substrate) is magnesium fluoride, the preferable refractive index for the layer closest to the substrate is about 1.68 (1.38 x √1.5). A suitable material for use in such an example is alumina, having a refractive index of about 1.63. Using the theory set forth above, the preferable physical thickness of the alumina and magnesium fluoride layers is about 86 nanometers (140 ÷ 1.63) and 101 nanometers (140 ÷ 1.38), respectively.

A traditional three layer anti-reflective coating has a first layer that is of quarter wave optical thickness, a second layer of half wave optical thickness, and a third layer of quarter wave optical thickness, such that the composite coating is a full wave optical thickness. For anti-reflective coatings greater than three layers, there are no preferable theoretical relationships for the optical thickness and refractive index of the individual layers, but coating systems can be modeled and developed by specifying the desired refractive indices, selecting desired coating materials, and calculating the preferable thickness for each layer. For coating systems having three or more layers, it is possible to obtain desirable results using only two anti-reflective materials. Anti-reflective coating materials and the design and modeling of single or multilayer anti-reflective coating systems are known to those of skill in the anti-reflective coating art and one could readily select an appropriate anti-reflective coating system for the invention herein.

### EXAMPLES

To further illustrate the principles of the present invention, the following examples are put forth so as to provide those of ordinary skill in the art with a complete disclosure and description of how the light emitting devices and methods for eliminating Newton's Rings can be made and evaluated. They are intended to be purely exemplary of the invention and are not intended to limit the scope of what the inventors regard as their invention. Efforts have been made to ensure accuracy with respect to numbers (e.g., thickness, index of refraction, etc.); however, some errors and deviations should be accounted for. There are numerous variation and combinations of conditions, e.g. coating components, the refractive properties of each component, and deposition techniques that can be used to optimize device performance. Only reasonable and routine experimentation will be required to optimize such conditions.

All of the light emitting devices of the recited examples were modeled to determine reflection of ambient light at various angles of incidence, such as for example, 0, 30, and 60 degrees. All values included herein are based on theoretical models. As such, any specific values recited are intended to serve as approximations, and can vary depending on other device and experimental conditions. For all examples, methods to deposit coatings are known in the industry and one of skill in the art would be able to readily select an appropriate coating deposition technique.

**Example 1 - Single Layer MgF₂** coating

In a first example, a single layer magnesium fluoride coating was modeled on one surface of a piece of Eagle ^{2000 ™} glass, simulating the inner surface of a light emitting device cover substrate. The refractive index of the Eagle ^{2000 ™} glass of this example is 1.507 at 589.3 nanometers, and thus, according to the theory set forth above, the anti-reflective coating has a target refractive index of 1.23 and an optical thickness of 147 nanometers. A single layer magnesium fluoride coating has a refractive index of 1.38, and thus a physical thickness of about 107 nanometers.

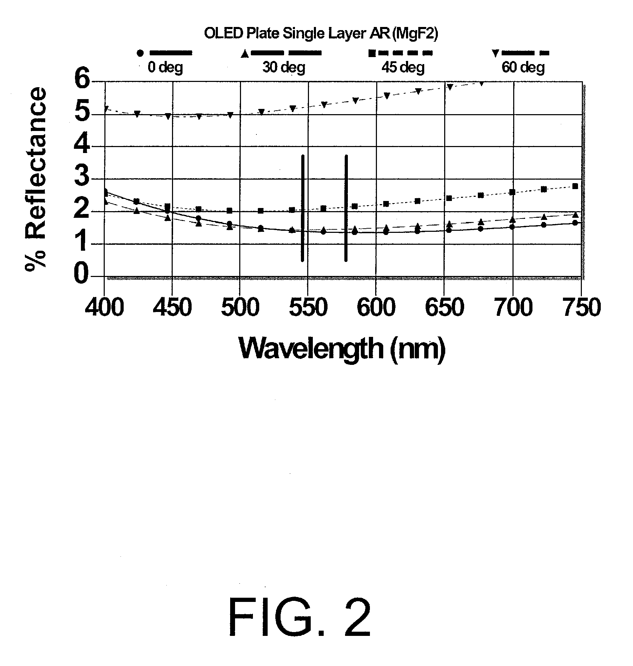

FIG. 2 illustrates the modeled reflectivity of light at various angles of incidence for the single layer magnesium fluoride coating. At a wavelength of 546 nanometers, the reflectance is approximately 1.4 % when viewed from an angle of incidence of from 0 to 30 degrees. At a 45 degree angle of incidence, the reflectance is slightly greater than 2 percent, and at a 60 degree of incidence, the reflectance is greater than 5 percent.

**Example 2 - Multi-Layer Coatings**

In a second set of examples, a series of models were conducted to determine reflectivity of ambient light for a cover substrate coated with a multi-layer anti-reflective coating. A three layer and a twelve layer anti-reflective coating were modeled at various angles of incidence. The three layer coating model represents a typical anti-reflective coating design on an Eagle ^{2000 ™} glass substrate. The index of refraction and physical thickness of each of the 3 layers were: 1.62 and 83 nanometers; 2.32 and 116 nanometers; and 1.38 and 98 nanometers, respectively. The twelve layer coating was more complex, requiring substantially thinner layers, and as such, optimization was performed by computer to accommodate the large number of variables.

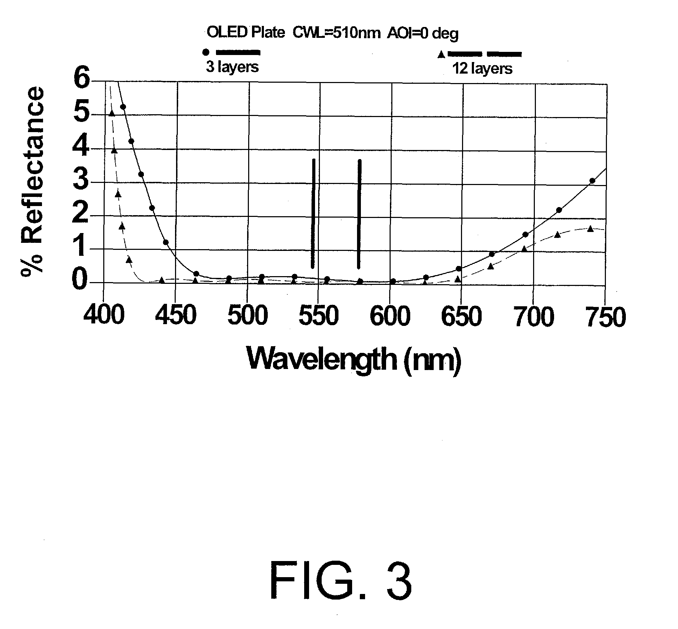

FIG. 3 illustrates the modeled reflectivity of light at an angle of incidence of 0 degrees for both a 3 layer and a 12 layer anti-reflective coating. For both coatings, reflectance was significantly below 1 percent at 546 nanometers, in accordance with the present invention.

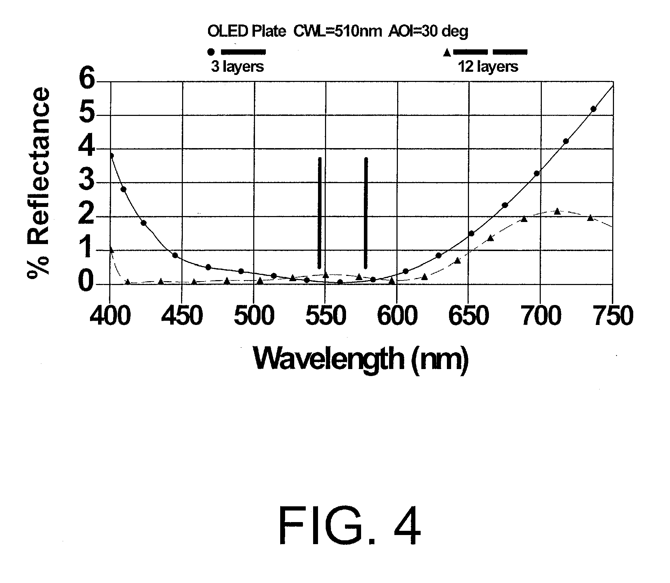

FIG. 4 illustrates the modeled reflectivity of light at an angle of incidence of 30 degrees for both a 3 layer and a 12 layer anti-reflective coating. For both coatings, reflectance was significantly below 1 percent at 546 nanometers, in accordance with the present invention. The 3 layer coating has a reflectance of about 0.3 %, compared to approximately 1.4 % for the single layer magnesium fluoride coating of Example 1.

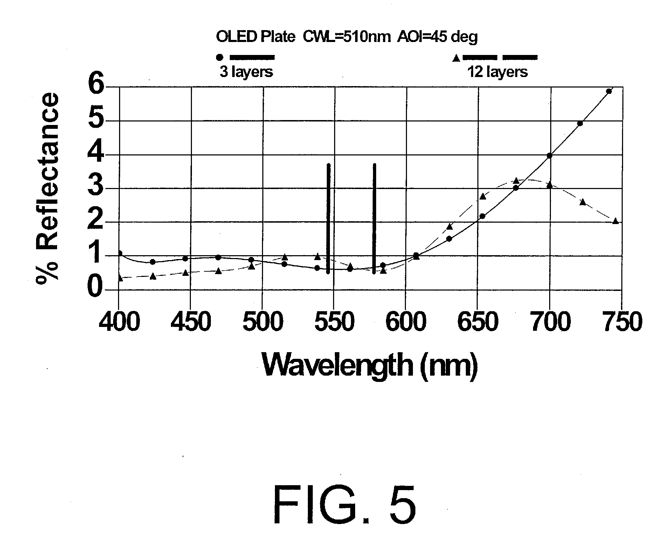

FIG. 5 illustrates the modeled reflectivity of light at an angle of incidence of 45 degrees for both a 3 layer and a 12 layer anti-reflective coating. For both coatings, reflectance was below 1 percent at 546 nanometers, in accordance with the present invention.

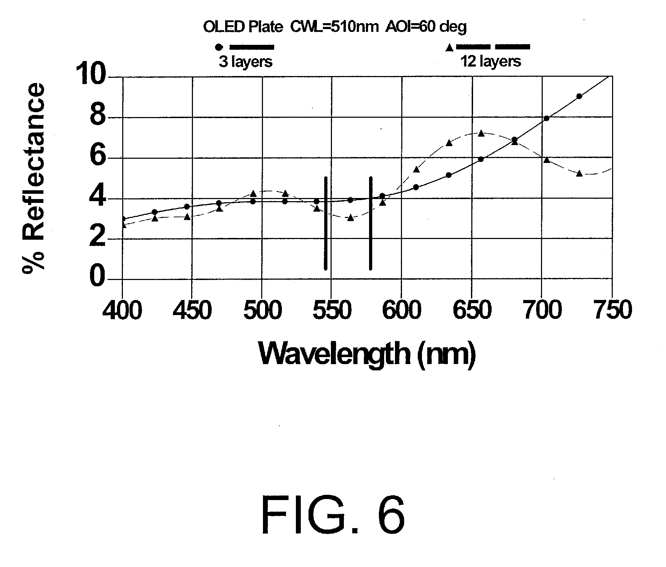

FIG. 6 illustrates the modeled reflectivity of light at an angle of incidence of 60 degrees for both a 3 layer and a 12 layer anti-reflective coating. For both coatings, reflectance was between about 3 and about 4 percent. While Newton's Rings can be visible in some applications, the reflectance of ambient light with the coatings of this example remain significantly reduced from that of a single layer magnesium fluoride coating as depicted in FIG. 2. According to the calculated models, layers greater in number to 3 may not be necessary to reduce Newton's Rings.

**Example 3 - Four Layer Anti-Reflective Coating**

In still a third example, a four layer anti-reflective coating was modeled on an Eagle ^{2000 ™} cover substrate. The four layer coating comprised 12 nanometers niobium oxide, about 36 nanometers silica, about 110 nanometers niobium oxide, and a top layer of 90 nanometers silica.

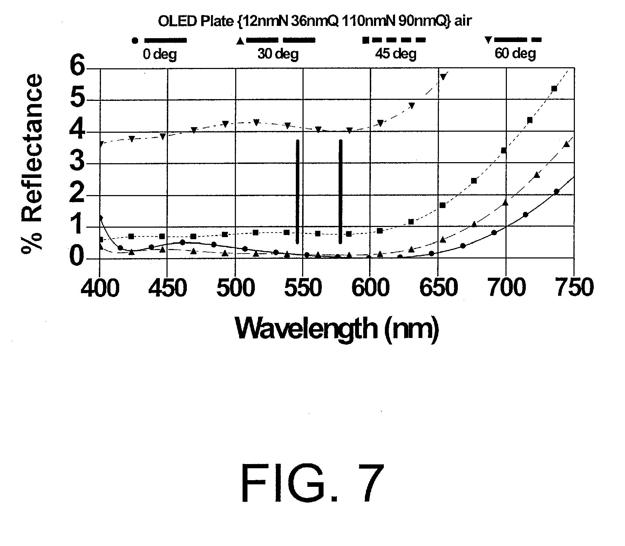

As illustrated in FIG 7, the modeled reflectance of light at angles of incidence up to 45 degrees is less than 1 percent for visible wavelengths below 630 nanometers. This model suggests that this coating composition is sufficient to reduce observation of Newton's Rings at angles of incidence up to about 45 degrees.

Throughout this application, various publications are referenced. The disclosures of these publications in their entireties are hereby incorporated by reference into this application in order to more fully describe the compounds, compositions, and methods described herein.

It should also be understood that while the present invention has been described in detail with respect to certain illustrative and specific aspects thereof, it should not be considered limited to such, as numerous modifications are possible without departing from the broad scope of the present invention as defined in the appended claims.

## Claims

1. A light emitting device comprising:
a cover substrate capable of transmitting light and having a first surface and a second surface oppositely disposed from the first surface;
a support substrate; and
a light emitting layer positioned between the cover substrate and the support substrate, wherein the light emitting layer emits light in the direction of the first surface of the cover substrate, and wherein the first surface of the cover substrate is coated with an anti-reflective material.

2. The light emitting device of Claim 1, wherein the anti-reflective material has an index of refraction approximately equal to the square root of the index of refraction of the cover substrate.

3. The light emitting device of Claim 1, wherein the optical thickness of the anti-reflective material coating is approximately equal to the wavelength of emitted light divided by four.

4. The light emitting device of Claim 1, wherein both the first and second surfaces of the cover substrate are coated with an anti-reflective material.

5. The light emitting device of Claim 1, wherein the reflectance of 460 nm to 640 nm incident light from the first surface of the cover substrate is less than 1 percent, when viewed from an angle of incidence of from 0 to about 30 degrees.

6. The light emitting device of Claim 1, wherein the reflectance of 546 nm and 575 nm incident light from the first surface of the cover substrate is less than 1 percent, when viewed from an angle of incidence of from 0 to about 45 degrees.

7. The light emitting device of Claim 1, wherein the light emitting layer is an organic light emitting diode.

8. The light emitting device of Claim 1, wherein the light emitting layer is a top light emitting diode emitting light through the cover substrate.

9. The light emitting device of Claim 1, wherein the anti-reflective material is an inorganic material.

10. The light emitting device of Claim 1, wherein the anti-reflective material comprises at least one of magnesium fluoride, niobium oxide, silica, silicon monoxide, tantala, zirconia, titania, alumina, yttria, hafnia, scandia, tin oxide, cerium oxide, or a mixture thereof.

11. The light emitting device of Claim 1, wherein the coating of anti-reflective material comprises at least two layers.

12. The light emitting device of Claim 1, wherein the coating of anti-reflective material comprises at least three layers.

13. The light emitting device of Claim 1, wherein the coating of anti-reflective material is four layers.

14. The light emitting device of Claim 1, wherein the cover substrate comprises glass.

15. The light emitting device of Claim 1, wherein the cover substrate comprises plastic.

16. A method of making a light emitting device comprising:
providing:
(1) a cover substrate capable of transmitting light and having a first surface and a second surface oppositely disposed from the first surface, wherein the first surface is coated with an anti-reflective material;
(2) a support substrate; and
(3) a light emitting layer; and
positioning the light emitting layer between the cover substrate and the support substrate such that the light emitting layer emits light in the direction of the first surface of the cover substrate.

17. The method of Claim 16, wherein both the first and second surfaces of the cover substrate are coated with an anti-reflective material.

18. The method of Claim 16, wherein the light emitting layer is an organic light emitting diode.

19. The method of Claim 16, wherein the anti-reflective material comprises at least two layers.

20. A method for reducing the formation of Newton's Rings in a device comprising:
providing the device of Claim 1; and
receiving ambient light onto the light emitting layer;
thereby preventing at least a portion of the internally reflected ambient light from traversing the cover substrate.
